(19)

**Europäisches Patentamt**
**European Patent Office**
**Office européen des brevets**

(11) **EP 4 738 703 A1**

(12) **EUROPEAN PATENT APPLICATION**

(43) Date of publication:
**06.05.2026 Bulletin 2026/19**

(21) Application number: **25208093.2**

(22) Date of filing: **10.10.2025**

(51) International Patent Classification (IPC):
**H03F 3/45** *(2006.01)*

(52) Cooperative Patent Classification (CPC):
**H03F 3/45475; H03F 3/45183; H03F 3/45977;**
**H03F 3/45995;** H03F 2200/375; H03F 2203/45048;
H03F 2203/45678; H03F 2203/45681

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH LA MA MD TN**

(30) Priority: **29.10.2024 IT 202400024186**

(71) Applicant: **STMicroelectronics International N.V.**
**1228 Plan-les-Ouates, Geneva (CH)**

(72) Inventors:
• **NICOLOSI, Alessandro**
 **I-20070 Dresano (Milano) (IT)**
• **ELGANI, Alessia Maria**
 **I-40124 Bologna (IT)**
• **ROSSI, Sandro**
 **I-27100 Pavia (IT)**

(74) Representative: **Buzzi, Notaro & Antonielli d'Oulx**
**S.p.A.**
**Corso Vittorio Emanuele II, 6**
**10123 Torino (IT)**

(54) **A METHOD OF OPERATING A DIFFERENTIAL AMPLIFIER ARRANGEMENT, CORRESPONDING DIFFERENTIAL AMPLIFIER, INTEGRATED CIRCUIT AND SYSTEM**

(57) A method of operating an amplifier circuit configured to provide an output signal at an output node based on an amplifier offset and at least one input signal received at input nodes of the amplifier circuit. The amplifier circuit further comprises at least one adjustment node configured to receive at least one adjustment signal. The method comprises, during a calibration phase of the amplifier circuit: selectively coupling the input nodes to a common calibration node and applying (110, 111) a common calibration voltage level thereto; iteratively varying (112, 114) the at least one adjustment signal based on a programmable control code (W) and applying the at least one varied adjustment signal to the at least one adjustment node; sensing the calibration output voltage produced at each iteration of the operation (112, 114) of varying the at least one adjustment signal and performing at least one comparison (116) among a i-th calibration output voltage provided by the amplifier and an (i+1)-th calibration output voltage; based at least on the comparison, checking (118) whether the (i+1)-th calibration output voltage has a polarity different from a polarity of the i-th calibration output voltage, and storing (119) the programmed value (W1) of the programmable control code (W) based on the positive result of the checking operation (118). The method further comprises, during an operating phase of the amplifier circuit: producing the at least one adjustment signal based on the stored (119) value (W1) of the control code (W) and applying the at least one produced adjustment signal to the at least one adjustment node as a result, and selectively decoupling the input nodes of the amplifier circuit from the common calibration node and applying at least one input signal to the input nodes of the amplifier circuit, providing an output signal at the output node of the amplifier circuit exempt from the amplifier offset as a result.

FIG. 10

**Description**

Technical field

The description relates to a method for operating differential amplifiers. One or more embodiments may relate to techniques for reducing an equivalent DC offset at input of such differential amplifiers.
One or more embodiments may be applied in a DC-DC converter, for example in battery monitoring systems equipped on-board battery-powered vehicles.

Technological background

Differential amplifiers are well-known in the art, and may be used e.g. in sensor circuits, comparators, integrators, etc.
Generally, differential amplifiers have a pair of input nodes receiving a differential input signal, and one or more output nodes (depending on whether the amplifier is in a single-ended or fully-differential configuration) configured to provide a differential output signal as an amplified version of the differential input signal. In an ideal scenario, the differential output signal is an amplified version of a difference between the input signals.
Conventionally, a DC offset at the output nodes may occur, that is a non-null output signal OUT occurring at the output nodes even if no input signal IN is applied to the input nodes. For example, the DC offset may be due to an internal offset, caused by mismatch of internal circuit components. Such DC offset (which may be represented by a small continuous $\Delta V$ placed at the input nodes of the amplifier even in the absence of the input signal) may result in an amplified output voltage $G*\Delta V$ at the output nodes, where G is a DC open loop gain of the amplifier. Considering that the open loop gain G may have a relatively high value, the DC offset at the output nodes may result in a non-negligible, constant unbalance, that may affect a dynamic range performance of the amplifier, for example the output signal OUT may be constantly saturated, thus hindering the amplifier performance. For example, while in an ideal operational amplifier having a gain G, e.g., G=3, an input voltage of 1 Volt is sufficient to produce an output voltage at a level of 3 Volts, the non-ideality may result in an input voltage about 0.99 Volts being sufficient to produce the desired output, resulting in an offset about 0.01 Volt.
Different solutions have been developed for the instant technical problem, for example:

US 2019/363686 A1 discusses a differential amplifier including: first and second input nodes; first and second output nodes; first and second supply nodes; first and second offset compensation nodes; first and second amplifier stages configured to generate first and second output voltages at the first and second output nodes as a function of first and second input voltages of the first and second input nodes and first and second offset compensation voltages of the first and second offset compensation nodes; and a feedback circuit configured to generate the first and second offset compensation voltages as a function of the first and the second output voltages; the feedback circuit includes: a coupling circuit coupled between the first and second offset compensation nodes, wherein the coupling circuit comprises one or more passive electric components;
US 2007/109043 A1 discusses a circuit for minimizing a voltage offset between inverting and non-inverting input terminals of an operational amplifier circuit, where the circuit includes a chopper circuit connected to the inverting and non-inverting input terminals of the operational amplifier circuit, the chopper circuit including: an amplifier having differential outputs; and a switching circuit for periodically reversing the input terminals to the amplifier and periodically reversing the outputs of the amplifier to provide an output signal having an offset adjustment signal to the operational amplifier circuit to adjust the offset of the operational amplifier circuit.

Existing techniques envisage reducing the DC offset of the differential amplifier by acting on the amplifier itself (e.g., increasing the size of the transistors or the gain value of the differential stage). Such solutions present the drawback of an increased power consumption.
Alternatively, either static compensation techniques (SCT) or dynamic compensation techniques (DCT) can be used. SCT techniques envisage applying a correction factor to the amplifier, where the correction factor is based on measurements performed while the application is not running (e.g., during manufacturing). The measured correction factor can be stored (e.g., in a non-volatile memory, NVM) and applied during operation of the amplifier. DCT techniques envisage dynamic removal of the offset from the output voltage and can be based on:

i) sampling the offset and its subtraction from the output (currently referred to as auto-zeroing);
ii) modulation of the offset to high frequency (e.g., through chopping at a frequency higher than the input signal frequency) and elimination from the output voltage by a low-pass or notch filter.

Both solutions involve the presence of a continuous clock (plus a storage element, e.g., capacitor, and an analog filter), which can increase energy consumption. Moreover, SCT have an increased area footprint due to the presence of the NVM and can become less reliable over the entire lifetime of the circuitry.

A reduced offset can be relevant in particular for analog closed-loop regulation, such as control loop for DC/DC converter or sensing applications, such as battery monitoring systems (BMS) for automotive application.

Object and summary

An object of one or more embodiments may be that of providing a method that may facilitate overcoming the disadvantages previously outlined. Such disadvantages may be reduced by means of a method having the features set forth in the claims that follow.

One or more embodiments may include a corresponding differential amplifier circuit.

For instance, an integrated circuit (IC) including the differential amplifier may be exemplary of such a circuit.

One or more embodiments may include a corresponding system (e.g. a DC-DC converter).

The claims are an integral part of the disclosure of the invention as provided herein.

One or more embodiments facilitate reducing area occupancy with respect to SCT, thanks to the reduced memory area impact.

One or more embodiments facilitates monitoring the offset and canceling it via an "on-demand" calibration procedure, thereby reducing power consumption with respect DCT.

One or more embodiments exploit the network of the amplifier (e.g., RC Miller) as a clock generator. For instance, this leads to a simplified structure and reduced costs.

One or more embodiments facilitate an "on-demand" launch of the offset compensation method, during idle conditions of the amplifier. For instance, the method runs at each power-on and whenever the amplifier can be temporally disconnected (for instance, while entering sleep-modes).

One or more embodiments facilitate compensating drifts in performance due to aging of the electronic components.

One or more embodiments can dispense from the use of filters in case of offset modulation (currently referred to as chopping).

Brief description of several views of the drawings

One or more embodiments will now be described, by way of example only, with reference to the annexed figures, wherein:

Figures 1 and 2 are diagrams exemplary of principles underlying one or more embodiments;
Figure 3 is a diagram exemplary of a differential amplifier according to one or more embodiments;
Figure 4 is a diagram exemplary of an alternative of a differential amplified for use in one or more embodiments;
Figure 5, comprising parts a) and b), is a diagram exemplary of a circuit block as per the present disclosure;
Figure 6 is a diagram exemplary of a circuit suitable for use in one or more embodiments;
Figures 7 and 8 are diagrams exemplary of an evolution over time of signals in one or more embodiments; and
Figure 9 is a diagram exemplary of non-limiting scenarios of systems employing a differential amplifier according to one or more embodiments;
Figure 10 is a diagram exemplary of a method as per the present disclosure; and
Figure 11 is a diagram exemplary of principles underlying one or more embodiments.

Detailed description

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment. Moreover, particular conformations, structures, or characteristics may be combined in any adequate way in one or more embodiments.

The references used herein are provided merely for convenience and hence do not define the extent of protection or the scope of the embodiments.

As mentioned, applications such as analog closed-loop regulation (e.g., control loop for DC/DC converter) involve a reduced error tolerance (less than 1%) on the regulated voltage. Also, sensing applications in can involve a low margin (less than 1mV error tolerance, where 1 mV = $10^{-3}$ V = 1 milliVolt).

One or more embodiments facilitate providing a reduced DC offset (e.g., in a range 0.01-0.1 mV) for a differential amplifier.

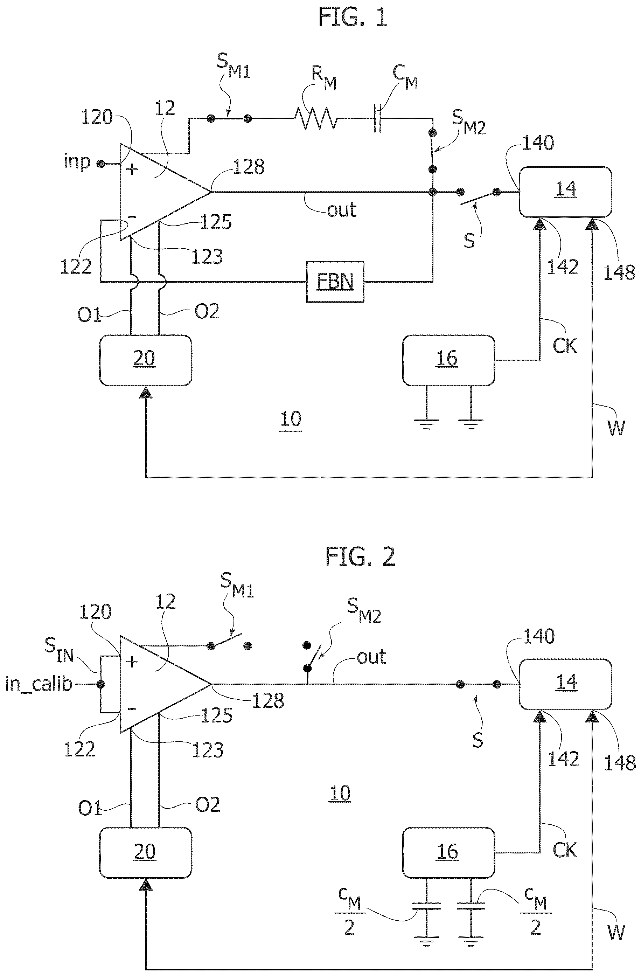

As exemplified in Figures 1 and 2, a differential amplifier arrangement 10 as per the present disclosure comprises:

an operational amplifier 12 comprising a first input node 120, a second input node 122 and an output node 128 as well as supply nodes (not visible in Figure 1); moreover, the operational amplifier 12 comprises a first (e.g., positive) offset compensating node 123 and a second (e.g., negative) offset compensating node 125 configured to be coupled to an offset compensating circuitry 20, as discussed in the following;

a set of switches Sin, SM1, SM2, S comprising switches configured to be made selectively conductive or non-conductive based on control signals received from a digital circuit block 14;

a Miller compensation network $R_M$, $C_M$ comprising a resistive circuit element RM and a capacitive circuit element $C_M$ coupled (e.g., in series) to each other; for instance, the Miller compensation network $R_M$, $C_M$ is configured to be coupled across the operational amplifier 12, in a manner per se known;

the digital control circuit block 14 having a first input node 140 coupled to the output node 128 of the operational amplifier 12, a second input node 142 configured to be coupled to an oscillator to receive a clock signal CK therefrom, and an output node 148 configured to provide a digital control code W to the offset compensating circuitry 20, the digital control circuit block 14 further configured to provide control signals to switches in the set of switches Sin, SM1, SM2, S; and

the offset compensating circuit block 20 coupled to the digital control block 14 and to the operational amplifier 12 and configured to provide an offset-compensating signal thereto based on the digital control code W received from the digital control circuit block 14.

As exemplified in Figures 1 and 2, the arrangement 10 operates differently in different operational phases. For instance:

as exemplified in Figure 1, during a functional phase, the first input node 120 is configured to receive an input signal INP, the second input node 122 forms a feedback network FBN (e.g., a simple connection or a resistive or capacitive network) with the output node 128, and the Miller compensation network $R_M$, $C_M$ is selectively coupled (e.g., via interposed switch $S_M$) to the operational amplifier 12; still in the functional phase, the digital block 14 and the oscillator 16 are selectively decoupled (e.g., via interposed switch S) from the remaining blocks 12, 20 of the arrangement 10;

as exemplified in Figure 2, during a calibration phase, the first input node 120 and the second input node 122 of the operational amplifier 12 are coupled therebetween and are configured to receive a same calibration level IN_CALIB; still in the calibration phase, the Miller compensation network $R_M$, $C_M$ is de-coupled (e.g., via interposed switches $S_{M1}$, $S_{M2}$) to the operational amplifier 12 while the digital block 14 and the oscillator 16 are coupled (e.g., via interposed switch S) to circuit blocks 12, 20 of the arrangement 10.

As exemplified in Figure 2, the capacitive element $C_M$ of the Miller compensation network is coupled (e.g., as two capacitive elements CM/2 each having half or different complementary ratios of the total capacitance $C_M$) to the oscillator 16 to facilitate its operation, advantageously reducing the area occupancy of the circuit 10.

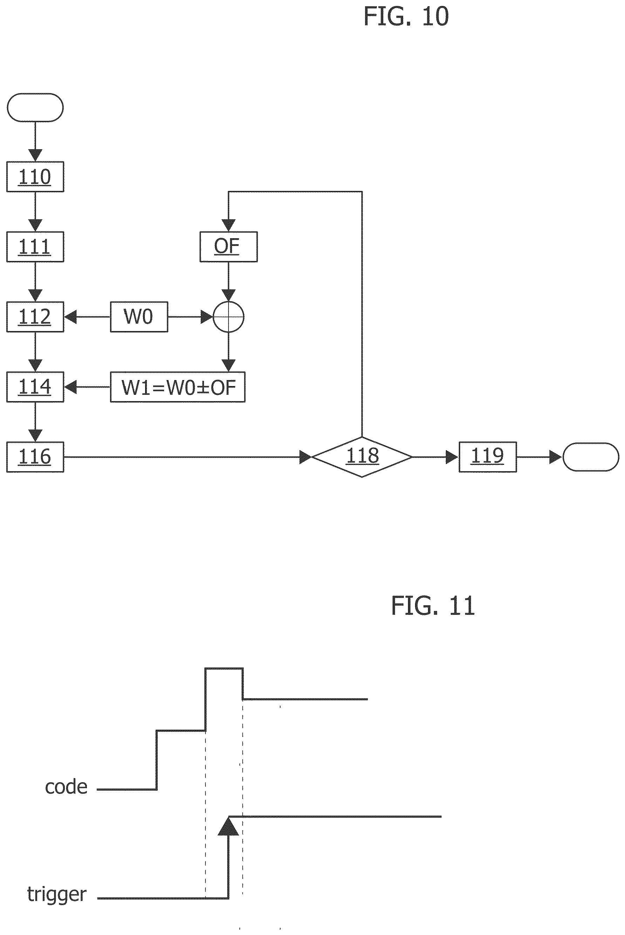

As exemplified in Figure 10, a method of operating the differential amplifier arrangement 10 comprises:

block 110: coupling (e.g., via an interposed switch S) the output node 128 of the amplifier 12 to the digital control circuit 14;

block 111: de-coupling (e.g., via interposed switches SM1, SM2) the Miller network RM, CM from amplifier 12 and coupling (e.g., via an interposed switch Sin) the input nodes 120, 122 of the amplifier 12 to a same calibration node and applying a same voltage level IN_CALIB at both input nodes 120, 122 of the amplifier 12,

block 112: setting the value of the digital control code W (e.g., to an initial digital code value WO) and providing the digital control code W to the offset compensating circuit block 20, driving the latter to apply a first set of offset compensating signals (e.g., current signals O1, O2) to the offset compensating nodes 123, 125 of the amplifier circuit 12, and sensing at the output node 128 a first output voltage OUT1 produced by the amplifier 12 while the calibration voltage level IN_CALIB is applied at its input nodes 120, 122 and the first set of offset-compensating signals is applied at its offset-compensating nodes 123, 125;

block 114: adjusting the value of the digital control code W (e.g., by an adjustable increment or decrement OF, so that a second digital code value W1 is equal to WO+OF) and providing the digital control code W to the offset compensating circuit block 20, driving the latter to apply a further set of offset compensating signals (e.g., current signals O1, O2) to the offset compensating nodes 123, 125 of the amplifier circuit 12, and sensing at the output node 128 a further output voltage OUT2 produced by the amplifier 12 while the calibration voltage level IN_CALIB is applied at its input nodes 120, 122 and the further set of offset-compensating signals is applied at its offset-compensating nodes 123, 125;

block 116: performing at least one comparison among the first output voltage OUT1 and the second output voltage OUT2; also, collecting data related to a direction of change of the digital control word W (e.g., increasing or decreasing) and, if present, of the value of the digital code used in a previous application of the calibration;

block 118: based at least on the comparison and/or on the collected data, checking whether the second output voltage OUT2 has at least a polarity (e.g., sign) different from the first output voltage OUT1;

block 119: in case of a positive check result from block 118, determining the digital code value (e.g., further value W1=WO+OF) provided to the offset-compensating circuit block 20 and labeling it as the code that cancels the offset of the amplifier circuit 12; otherwise, repeating the procedure and iteratively adjusting the value of the digital code word W until detecting a transition in the polarity of the output voltage OUT.

As exemplified herein, various kind of information, such as polarity change and/or evolution over time of the digital control word W, lead to determining the result of the check operation 118, which is therefore based on the comparison while also possibly including other types of processing of the aforementioned information.

For instance, in one or more embodiments block 118 comprises:

based on the comparison, the collected/detected direction of change and/or the collected/detected previous values of the digital code W, assessing (or checking) whether the second output voltage OUT2 has at least a polarity (e.g., sign) different from the first output voltage OUT1.

As exemplified in Figures 1 and 2, in passing from the functional mode to the calibration mode the compensation network $R_M$, $C_M$ can be decoupled from the amplifier 12 and coupled to the oscillator circuit 16 to provide capacitive elements for operating the oscillator. Alternatively, the dedicated oscillator circuit block 16 can be provided.

In order to minimize the area occupation, the RC Miller compensation network $R_M$, $C_M$ of the amplifier 12 or the RC compensation network for DC/DC converter loop stabilization can be coupled to the oscillator 16 during the calibration phase exemplified in Figure 10. In this way, the clock signal CK for the calibration logic can be generated without using extra area.

As exemplified in Figures 1, 2 and 10, the digital circuit block 14, synchronized by the clock signal CK received from the oscillator 16, provides the digital code W to drive the offset-compensating block 20 to vary the offset-compensating signals O1, O2 to provide to offset-compensating nodes 123, 125 of the amplifier 12.

As the input digital code W varies it value, the output OUT of the amplifier 12 varies its value. During such a variation, the polarity of the output signal will invert at a certain point. For instance, in an exemplary scenario in which the digital code monotonically varies the offset, the digital control code W corresponding to a polarity inversion of the output signal OUT is stored (e.g., in a flip-flop, not visible in the figures) up to the next time the offset compensation routine is performed.

For instance, in an alternative exemplary scenario in which the variation of the offset is not monotonical, the digital code to store may still correspond to the one which causes an inversion in the polarity of the output signal OUT in response to applying the minimum compensation signal via circuit 20.

As exemplified in Figures 1 and 2, one or more internal terminals of the amplifier are accessible to intentionally inject an additional offset. This offset is added with discrete contributions to compensate for the original offset via the offset-compensating circuit block 20.

For instance, the output of the amplifier is digitalized by means of a trigger (not visible in the figure), in a manner per se known.

For instance, the trigger may be operated with a programmable threshold value so that it can be varied based on the application (e.g., conventional DC value).

It is noted that, in case of a high gain amplifier (such as a two-stage amplifier with voltage gain higher than 120 dB), the effect of the trigger threshold becomes negligible. In other cases, the residual offset is equal to the offset of the trigger divided by the amplifier gain.

As exemplified herein, the method to operate the arrangement 10 can be executed "on-demand". For instance, it can be run at each power-on and/or whenever the amplifier can be temporally disconnected (for instance, while entering sleep mode).

As exemplified herein, the algorithm is implemented by using synchronous logic with the clock signal CK enabled solely during the calibration phase.

As mentioned, in an exemplary scenario, when the digital circuit block 14 is activated during the calibration phase, some or all the possible values for the digital code W are swept, corresponding to a (e.g., full) sweep of offset-compensating signal values (e.g., from zero to a maximum bias current Imax); the selected offset-nulling digital code value (e.g., W1) is the one at which the output voltage OUT toggles.

As exemplified in Figures 10 and 11, in a first exemplary scenario, a single-ramp clock sweeping method can be used, comprising:

scanning the control signal code once in one direction looking for trigger commutation;
removing half of the least-significant bit (LSB) from the final value to get a residual offset with a spread of one LSB peak-to-peak centered in zero.

In a second exemplary scenario, a dual-ramp sweeping method can be used, comprising:

scanning digital control codes in both directions;
checking both codes corresponding to rising edge and falling edge of the trigger, and
computing the best code value based on these two values.

In a third exemplary scenario, a tracking-mode sweeping method can be used to speed-up the calibration phase, comprising scanning the digital control codes starting from the latest best value found during the previous run.

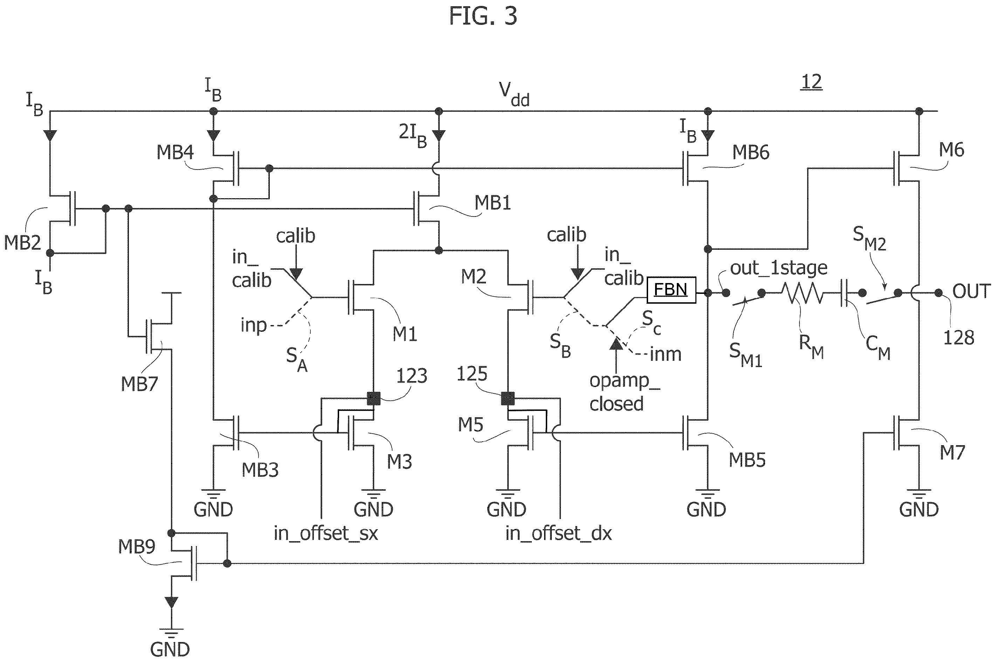

Figure 3 is a diagram exemplary of an amplifier circuit 12 as per the present disclosure.
In the following figures, parts or elements like parts or elements already discussed in connection with Figure 1 and 2 are indicated with like references and a corresponding detailed description will not be repeated for the sake of brevity. Also, for the sake of simplicity and ease of understanding, in the instant description the differential amplifiers according to one or more embodiments are exemplified as comprising n-channel or p-channel Metal Oxide Semiconductor Field Effect Transistors MOSFETs having gate terminal, source terminal and drain terminal. However, those of skill in the art will otherwise understand that other types of components may be employed for the realization of the differential amplifiers, such as other types of Field Effect Transistors or Bipolar Junction Transistors BJT.
As exemplified in Figure 3, the operational amplifier circuit 12 comprises:

a differential pair of transistors M1, M2 having respective control nodes corresponding to input nodes 120, 122 of the operational amplifier 12; each transistor in the differential pair of transistors M1, M2 has a respective current flow path therethrough from a common (e.g., source) node to a respective current (e.g., drain) node 123, 125;
a first set of transistors M3, M5 comprising a first transistor M3 and a second transistor M5 in diode configuration and respective current (e.g., drain) nodes coupled to the current (e.g., drain) nodes 123, 125 of the differential pair of transistors M1, M2;
a further set of transistors MB1, MB2, MB7, MB9 comprising a set of current mirror arrangements of transistors to mirror a given bias current $I_B$,
an output stage comprising transistor M6 and bias mirroring transistor M7 coupled to the differential pair of transistors M1, M2 via transistors M3, M5, MB3, MB4, MB5, MB6 in the further set of transistors.

As exemplified in Figures 1 to 3, the current (e.g., drain) nodes of the first differential stage of transistors M1, M2 are coupled to the offset-compensating circuit block 20 which is configured to provide thereto (e.g. at nodes 123, 125) compensating current signals in_offset_sx, in_offset_dx (corresponding to signals O1, O2 exemplified in Figure 2) in order to sweep the offset values of the amplifier 12 during the calibration phase (exemplified in Fig. 2) and to provide a constant compensation during normal operation of the amplifier 12 (exemplified in Fig. 1).
As exemplified in Figure 3, the amplifier 12 further comprises:

at least one switch $S_A$, $S_B$, $S_C$ configured to selectively couple (based on control signals CALIB, OPAMP_CLOSED from the digital control circuit block 14) the input nodes 120, 122 of the amplifier 12 to the calibration level IN_CALIB or to the differential input signals INP, INM and/or to couple the second input node to the output node 128 in case the feedback network FBN is present;
at least one further switch SM configured to selectively couple (based on control signals from the digital control circuit block 14) the Miller network RM, CM to the output node 128 of the amplifier 12.

As exemplified in Figure 3, the first input node 120 of the amplifier 12 is selectively couplable to the input signal INP or the calibration signal(s) IN_CALIB based on a logic control signal CALIB driving a first switch $S_A$ to be closed or open based on the control signal CALIB having a first (e.g., "1" or "true") or second (e.g., "0" or "false") logic value, respectively.
As exemplified in Figure 3, the second input node 122 of the amplifier 12 is selectively couplable to the calibration signal(s) IN_CALIB based on a logic control signal CALIB driving a second switch $S_B$ to be closed or open based on the control signal CALIB having a first (e.g., "1" or "true") or second (e.g., "0" or "false") logic value, respectively. For instance, in case the control signal CALIB has the second logic value, a third switch Sc is driven by a further control signal OPAMP_CLOSED to selectively couple the second node to a further input signal INM or to the output node OUT of the amplifier 12 depending on whether the feedback loop is implemented.

It is noted that the number and position of switches exemplified in Figure 3 is purely exemplary and in no way limiting. In an alternative scenario, for instance, it may be possible to use a same switch Sc or a different arrangement of switches so as to obtain the same result of being able to select whether to use the operational amplifier 12 in an open or closed loop during the functional phase.

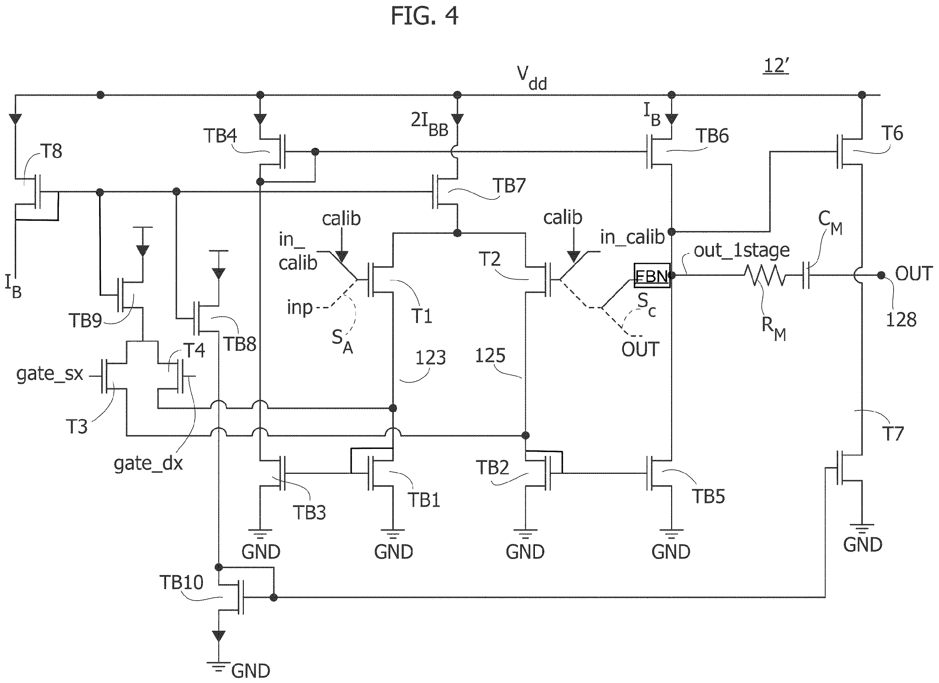

As exemplified in Figure 4, one or more embodiments may employ an alternative amplifier circuit 12', comprising:

a first differential pair of transistors T1, T2 having respective control nodes corresponding to input nodes 120, 122 of the operational amplifier 12'; each transistor of the differential pair of transistors T1, T2 has a respective current flow path therethrough from a common (e.g., source) node to a respective current (e.g., drain) node; for instance, the first differential pair of transistors T1, T2 have a first transconductance value gm1;

a second differential pair of transistors T3, T4 having respective control nodes gate_sx, gate_dx corresponding to offset-compensating nodes 123, 125 of the operational amplifier 12'; each transistor of the second differential pair of transistors T3, T4 has a respective current flow path therethrough from a common (e.g., source) node to the respective current (e.g., drain) node of a respective transistor in the first differential pair of transistors T1, T2; for instance, the second differential pair of transistors T3, T4 have a second transconductance value gm2;

a further set of transistors TB7, TB8, TB9, TB10, TB11 comprising a set of current mirror arrangements of transistors to mirror a (e.g., PTAT) current $I_{BB}$,

an output stage comprising transistor T6 and bias mirroring transistor T7, T8 coupled to the differential pair of transistors T1, T2 via transistors TB1-6 of the further set of transistors.

In the scenario exemplified in Figure 4, applying an offset voltage v_os to the additional differential pair T3, T4 corresponds to an equivalent injected offset current which can be expressed as:

$$i\_offset = v\_os * gm\_2;$$

$$v\_offset = i\_offset / gm1 = v\_os * (gm2)/(gm1)$$

where

gm_1 is the transconductance of the first differential pair T1, T2
$gm\_2$ is the transconductance of the second differential pair T3, T4 (e.g., gm2<<gm1).

It is advantageous to keep the ratio constant over temperature in order to keep the same offset current i_offset in order to counter the re-calibrations to perform at different temperatures. Thereby, it is preferable to have a constant transconductance gm_1 and gm_2, as it can be useful in many applications (constant bandwidth, constant gain in case the amplifier is used as an operational transconductance amplifier, OTA and so on.

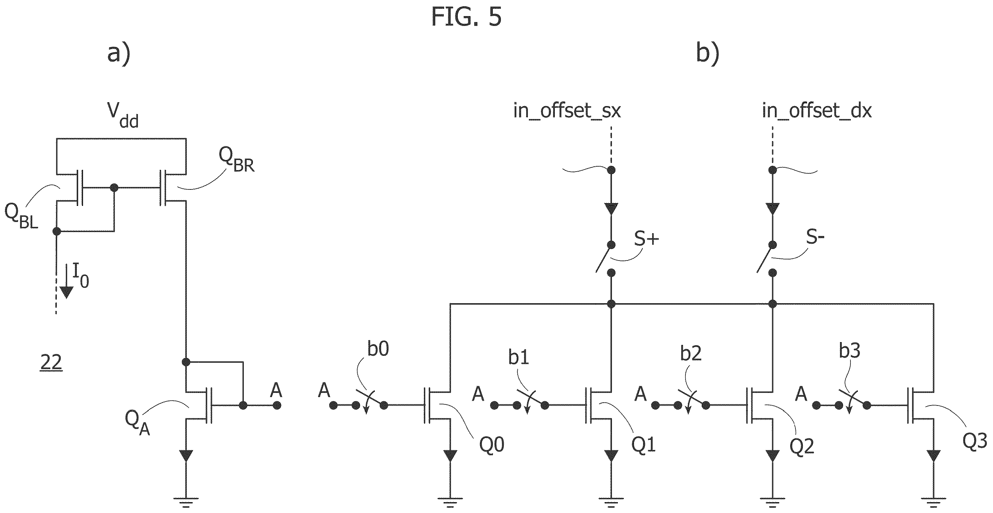

Figure 5 is a diagram exemplary of a non-limiting possible implementation of the offset-compensating circuit block 20.

As exemplified in Figure 5, a variable current can be generated by selectively coupling a selectable number of transistor gates Q0, Q1, Q2, Q3 to a same node A based on the values of each bit b0, b1, b2, b3 of the digital code word W.

It is noted that the number of bits (e.g., four) of the code word W and the number of transistors (e.g., four) Q0, Q1, Q2, Q3 exemplified in Figure 4 are purely exemplary, being otherwise understood that notionally any number of transistors and/or bits can be used in one or more embodiments.

As exemplified in Figure 5, an offset current i_offset generated by the selected digital code value W may be injected from the offset-compensating circuit block 20 as compensating signals in_offset_sx, in_offset_dx towards one of the compensating nodes 123, 125 of the circuit 12 exemplified in Figure 3 at the end of all iterations of the method exemplified in Figure 10.

As exemplified in portion b) of Figure 5, the offset compensating circuit block 20 comprises a variable current mirror, comprising:

a set of (e.g., four) parallel transistors Q0, Q1, Q2, Q3 referred to ground GND and having respective control nodes selectively couplable to a common node A via respective switches b0, b1, b2, b3;

a further set of switches S+, S- configured to selectively couple the parallel arrangement Q0, Q1, Q2, Q3 to the first input node 123 or the second input node 125 to provide the offset correcting current thereto.

As exemplified in portion a) of Figure 5, the offset compensating circuit block 20 further comprises stage 22 comprising transistor QA having its control node A configured to be coupled to the control nodes of the selected transistors in the set of transistors Q0, Q1, Q2, Q3, the transistor QA having the control node A further coupled to a further (e.g., drain) transistor node referred to ground GND. As exemplified in portion a) of Figure 5, the circuit 22 further comprises a current mirror arrangement of transistors QBL, QBR configured to mirror a polarization current I0. As exemplified in Figure 2, the goal of the circuit 22 is to generate voltage A to be applied to the control (e.g., gate) nodes of transistors in the set of transistors Q0, Q1, Q2, Q3 which are made conductive via respective switches in the set of switches b0, b1, b2, b3.

Using the arrangement exemplified in Figure 5, it is possible to compute an input equivalent injected offset voltage corresponding to a certain offset current i_offset as a function of a transconductance gm_1 of the input differential pair M1, M2. Such a ratio may be expressed as: V_offset = i_offset/gm_1

In an alternative scenario, the offset compensating block 20 envisages injecting the additional offset by applying a different bulk voltage on the two transistors M1, M2 of the main differential pair (for instance, through a DAC).

It is noted that the arrangement exemplified in Figure 5 is only exemplary and in no way limiting as one or more embodiments may use notionally any variable current generator circuit (known per se).

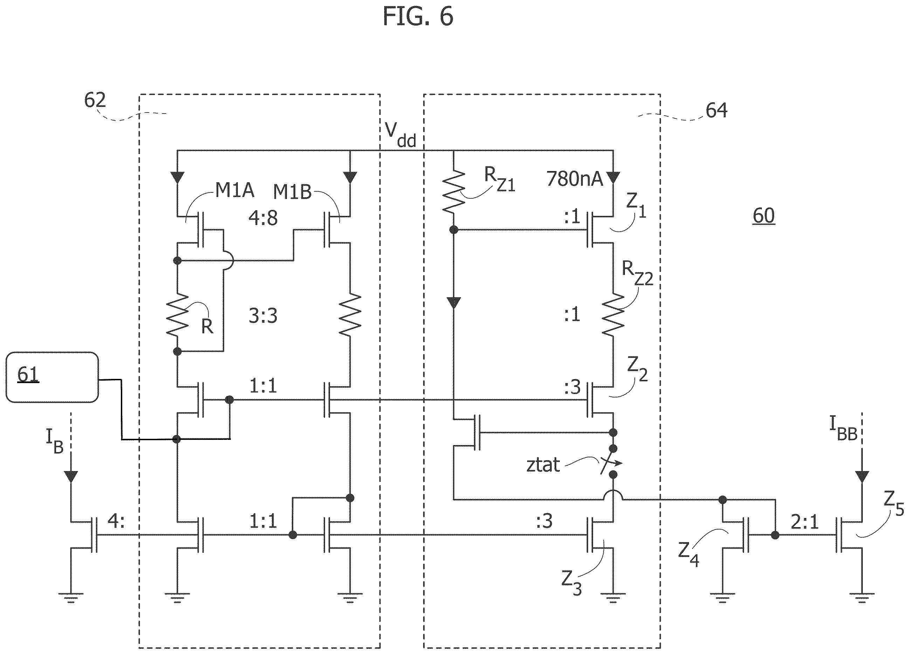

As exemplified in Figure 6, the temperature stability may be facilitated by providing a tail current IBB for the input differential pair T1, T2 of the arrangement exemplified in Figure 4 as well as for the input differential pair M1, M2 of the arrangement exemplified in Figure 3. As exemplified in Figure 6, the circuit has a positive temperature coefficient (proportional to absolute temperature - PTAT) to compensate for the variation of transconductance g_m in temperature, whereas the biasing current for stage 22 in Figure 5.a receives current Io ideally with a null temperature coefficient (invariant to absolute temperature - ZTAT) in order for current i_offset to be as flat as possible across temperature.

As exemplified in Figure 6, a circuit for providing a temperature-stable biasing current $I_B$ comprises:

> a first current generating circuit portion 62 comprising circuitry configured to generate a current proportional to absolute temperature, PTAT, and
> a second current generating circuit portion 64 comprising circuitry configured to generate the constant with temperature reference current (ZTAT) by forcing a PTAT current into a transistor with the appropriate dimensions to generate a ZTAT gate-to-source voltage, which is then applied across a resistor.

As exemplified in Figure 6, the PTAT circuit portion 62 is coupled to a startup circuit 61 and comprises a pair of transistors M1A and M1B matched to transistors M1, M2 used in the input differential pair, with M1B being N times the other transistor M1A.

As exemplified in Figure 6, circuit portion 64 comprises a first transistor Z1 having a size based on (e.g., via a size factor) the size of transistors in the pair of transistors M1A, M1B of circuit portion 62. For instance, the transistor Z1 is configured to draw a PTAT current that is a multiple (e.g., by a multiplication factor) of the current flowing through the transistors in the pair of transistors M1A, M1B, and further transistors Z4, Z5 in a current mirror arrangement and coupled to the first transistor Z1.

It is noted that the numbers (e.g., 4:8 and 3:3 close to transistors M1A, M1B, :1 close to transistor Z1, :3 close to transistors Z2, Z3 having a switch along their connection in the circuit portion 64) are purely exemplary and in no way limiting.

For instance, a voltage drop across control nodes (e.g., gate-to-source) of the first transistor Z1 of circuit portion 64 can be considered ZTAT. Therefore, considering the resistor Rz1 with a negligible temperature coefficient, also the current at output of current mirror arrangement Z4, Z5 maintained the property of being a ZTAT current. For instance, the intensity of the PTAT current may be about 260 nA (1 nA = 1 nanoAmpere = $10^{-9}$ Ampere) while the PTAT current through the transistor generating a ZTAT gate-to-source voltage may have an intensity about 780 nA, leading to an output ZTAT current about 1 microAmpere. The following table summarized the properties of the circuit exemplified in Figure 6 based on the operating region of M1A and M1B :

| MOS biased in <u>strong inversion</u> | MOS biased <u>weak inversion</u> |
|---|---|
| $$I_{\mathrm{PT}AT} = \frac{1}{2}\mu C'_{\mathrm{ox}} \frac{W}{L} V^2_{\mathrm{OV}_{M1A}} = \frac{1}{2}\mu C'_{\mathrm{ox}} N \frac{W}{L} V^2_{\mathrm{OV}_{M1B}} = \frac{1}{R^2}\left(1-\frac{1}{\sqrt{N}}\right)^2 \frac{2}{\mu C'_{\mathrm{ox}}\frac{W}{L}}.$$ | $$I_{\mathrm{PT}AT} = I_{D0}\frac{W}{L} e^{\frac{V_{GSA}-V_{TH}}{nV_T}} = I_{D0}N\frac{W}{L} e^{\frac{V_{GSB}-V_{TH}}{nV_T}} = \frac{\ln Nn V_T}{R}$$ |
| Considering IPTAT as bias current for each of the two transistors in the input differential pair M1, M2: | Considering IPTAT as bias current for each of the two transistors in the input differential pair M1, M2: |

(continued)

| MOS biased in <u>strong inversion</u> | MOS biased <u>weak inversion</u> |
|---|---|
| $g_{m1} = \sqrt{\mu C'_{ox} \frac{W}{L} I_{PTAT}} = \frac{2}{R}\left(1 - \frac{1}{\sqrt{N}}\right),$ | $g_{m1} = \frac{I_{PTAT}}{nV_T} = \frac{\ln N}{R}$ |

As appreciable by those of skill in the art, the differential transconductance (e.g., gm1) is constant or roughly constant with temperature in both biasing scenarios.

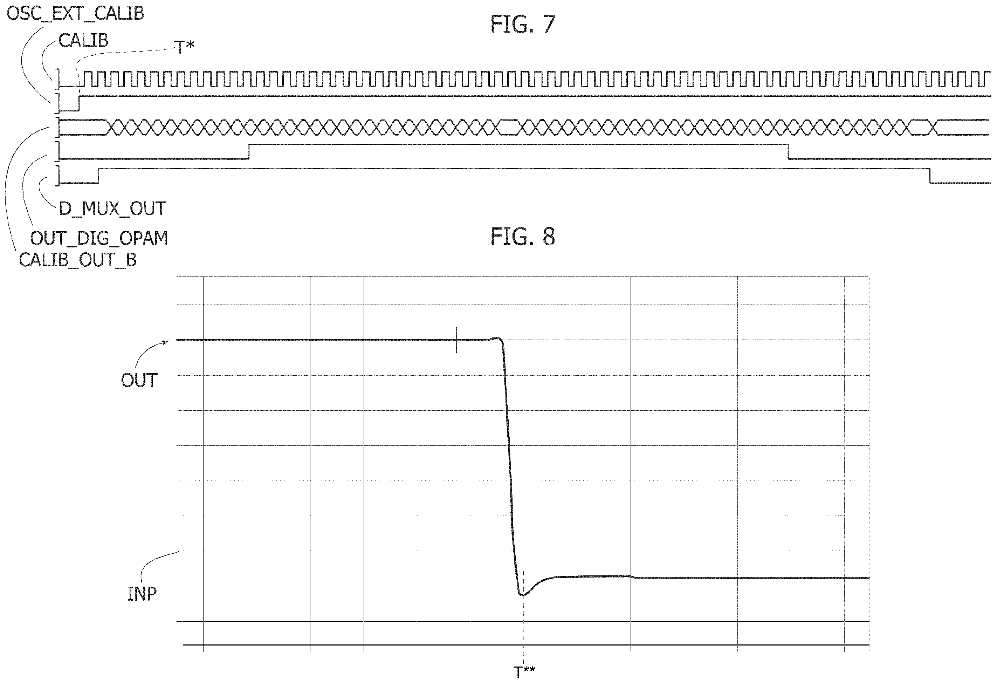

Figure 7 is a plot diagram (logic value, either '0' or '1', on the ordinate scale, time in seconds on the abscissa scale) of an evolution over time of signals in one or more embodiments.

For instance, signals evolving over time represented in Figure 7 comprise:

a clock signal OSC_EXT_CALIB which can be provided (as already discussed) via an external oscillator or generated internally 16, e.g., using the Miller capacity CM;
a register CALIB_OUT in which the values of the digital code W can be temporarily stored,
output signal OUT_DIG_OPAMP generated via a digitizing circuit (in a manner per se known, for instance via a window comparator) coupled to the output node 128 of the amplifier 12, 12'
transition signals CALIB, DMUX_OUT indicative of the beginning and the end of the calibration phase; for instance, a first transition signal CALIB is provided by the digital control circuit 14 to trigger the start of the calibration phase, while a second transition signal DMUX_OUT is provided by the digital control circuit 14 to keep track of the fact that the calibration phase is active (e.g., it is de-asserted to a zero logic level when the calibration phase ends).

As exemplified in Figure 7, for instance:

the calibration phase starts on demand by asserting the CALIB control signal (e.g., at time instant T* at the rising edge of the signal);
a value of the offset current i_offset is varied in response to varying the digital code stored in the register CALIB_OUT;
at the end of the calibration procedure, indicated by signal DMUX_OUT, the offset-nulling value of the digital code W is selected, thereby reducing the offset of the amplifier 12, 12'.

Figure 8 is a plot diagram (voltage in Volts on the ordinate scale, time in seconds on the abscissa scale) exemplary of the evolution over time of the output signal OUT from amplifier 12, 12' in the functional phase before and after (e.g., at time instant T**) applying the offset compensation 20 by driving the offset-compensating circuit 20 to produce the offset current i_offset using the selected value (at which the polarity of the output voltage changes during the calibration phase) of the digital code W provided by the digital circuit block 14 at the end of the calibration phase of the amplifier 12, 12'.

As exemplified in Figure 8, during the operating phase and before time instant T** the operational amplifier 12 in buffer configuration (as exemplified in Figure 1) receives an input voltage INP (e.g., about 2V) without compensation, the initial offset is about 3 mV. For instance, in response to the application of offset compensation after time instant T**, the offset is reduced to 0.38 mV (which is less than 1LSB in the specific implementation).

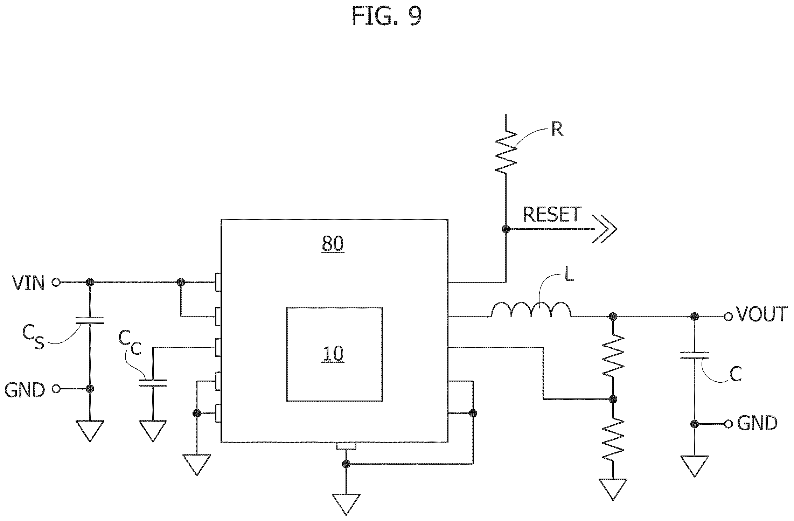

As exemplified in Figure 9, the arrangement 10 may be employed in different applications when an embedded offset reduction may be useful, e.g. in case the amplifier is used in DC-DC converter 80.

For example, the arrangement 12 may be used for compensating the offset of the error amplifier 12 present in the DC-DC converter 80 (e.g., the model known as L7983).

As exemplified in Figure 9, the DC-DC converter 80 equipped with the arrangement 10 may be coupled to:

a supply voltage source VIN, such as a battery filtered by capacitor CS referred to ground;
a biasing voltage source VCC, filtered by capacitive element CC;
a reactive load network L, C coupled to a switching node LX of the DC-DC converter 80 to provide the regulated output voltage VOUT across the capacitive element C;
a resistive feedback network to close the loop and set the final Vout value;
a resistive element for resetting the DC-DC converter operations.

Without prejudice to the underlying principles, the details and embodiments may vary, even significantly, with respect to what has been disclosed by way of example only, without departing from the extent of protection.

The extent of protection is defined by the annexed claims.

**Claims**

1. A method of operating an amplifier circuit (10, 12; 12') configured to provide an output signal (OUT) at an output node (128) based on an amplifier offset and at least one input signal (INP, INM) received at input nodes (120, 122) of the amplifier circuit (10, 12; 12'), wherein the amplifier circuit (10, 12; 12') further comprises at least one adjustment node (123, 125) configured to receive at least one adjustment signal (IN_OFFSET_SX, IN_OFFSET_DX; GATE_SX, GATE_DX), wherein the method comprises:

   during a calibration phase (T*) of the amplifier circuit (10, 12; 12'):

   selectively coupling ($S_{IN}$) the input nodes (120, 122) to a common calibration node and applying (110, 111) a common calibration voltage level (IN_CALIB) thereto;
   iteratively varying (112, 114) the at least one adjustment signal (IN_OFFSET_SX, IN_OFFSET_DX; GATE_SX, GATE_DX) based on a programmable control code (W) and applying the at least one varied adjustment signal to the at least one adjustment node (123),
   sensing a calibration output voltage (OUT) produced at each iteration (OUT1, OUT2) of the operation (112, 114) of varying the at least one adjustment signal (IN_OFFSET_SX, IN_OFFSET_DX; GATE_SX, GATE_DX) and performing at least one comparison (116) among a i-th calibration output voltage (OUT1) provided by the amplifier and an (i+1)-th calibration output voltage (OUT2);
   based at least on the comparison, checking (118) whether the (i+1)-th calibration output voltage (OUT2) has a polarity different from the polarity of the i-th calibration output voltage (OUT1), and
   storing (119) the programmed value (W1) of the programmable control code (W) based on the positive result of the checking operation (118);

   during an operating phase (T**) of the amplifier circuit (10, 12; 12'):

   producing the at least one adjustment signal (IN_OFFSET_SX, IN_OFFSET_DX; GATE_SX, GATE_DX) based on the stored (119) value (W1) of the control code (W) and applying the at least one produced adjustment signal (IN_OFFSET_SX, IN_OFFSET_DX; GATE_SX, GATE_DX) to the at least one adjustment node (123) as a result, and
   selectively decoupling ($S_{IN}$) the input nodes (120, 122) of the amplifier circuit (10, 12; 12') from the common calibration node and applying at least one input signal (INP, INM) to the input nodes (120, 122) of the amplifier circuit (10, 12; 12'), providing an output signal (OUT) at the output node (128) of the amplifier circuit (10, 12; 12') exempt from the amplifier offset as a result.

2. The method of claim 1, further comprising:
   during the second operating phase (T**) of the amplifier circuit (10, 12; 12'):

   selectively coupling the output node (128) of the amplifier circuit (10, 12; 12') to a Miller compensating stage ($R_M$, $C_M$);
   selectively coupling (CALIB, $S_A$) a first amplifier input node (120) of the amplifier circuit (10, 12; 12') to a first input node (INP) to receive a first input signal (INP) therefrom;
   selectively coupling (OPAMP_CLOSED, $S_B$, Sc) a second amplifier input node (122) to a second input node (OUT, INM) comprising either a second node (INM) to receive a second input signal therefrom or the output node (128) of the operational amplifier (12) to form a closed loop therewith.

3. The method of claim 1 or claim 2, comprising:

   triggering the start of the calibration phase of the amplifier circuit (10, 12; 12') in response to asserting (14) a calibration control signal (CALIB) with a first logic value; and/or
   de-asserting a calibration control signal (D_MUX_OUT) with a second logic value, thereby detecting the end of the calibration phase and the start of the operating phase of the amplifier circuit (10, 12; 12').

4. The method of any one of the previous claims, wherein performing said at least one comparison (116) among the i-th output voltage (OUT1) and the (i+1)-th output voltage (OUT2) during the calibration phase (T*) of the amplifier circuit (10, 12; 12') comprises:

   selectively coupling (110; S) the output node (128) of the amplifier circuit (10, 12; 12') to a sensing node (140) of a digital circuit block (14);

providing (16) a clock signal (CK) to the digital circuit block (14);

via said digital circuit block (14), performing analog-to-digital, ADC conversion (127) of the i-th output signal (OUT1) and the (i+1)-th output signal (OUT2), obtaining a i-th digital output (OUT_DIG_OMPAMP) and a (i+1)-th digital output as a result; and

performing at least one comparison between the i-th digital output (OUT_DIG_OMPAMP) and the (i+1)-th digital output,

in response to a negative result of the checking operation (118), varying the i-th control code value (W1) by a programmable amount (OF).

5.  The method of claim 4, wherein providing said clock signal (CK) to the digital circuit block (14) comprises selectively decoupling said Miller compensating stage ($R_M$, $C_M$) from the output node (128) of the amplifier circuit (10, 12; 12') and coupling said Miller compensating stage ($R_M$, $C_M$) to an oscillator circuit block (16) to provide said clock signal (CK) to the digital circuit block (14).

6.  The method of any one of the previous claims, wherein applying said at least one adjustment signal (IN_OFFSET_SX, IN_OFFSET_DX; GATE_SX, GATE_DX) to said at least one adjustment node (123, 125) of the amplifier circuit (10, 12; 12') comprises providing a digital counter and driving a variable current generator (20) to generate a current signal (I_OFFSET) based on the digital signal (OUT_DIG_OPAMP) provided by the digital counter.

7.  The method of claim 6, comprising:

    monotonically increasing a digital signal (W) provided by said digital counter, providing a first ramp in which the offset current (I_OFFSET) monotonically increases, and monotonically decreasing the digital signal (W) provided by said digital counter, providing a second ramp in which the offset current (I_OFFSET) monotonically decreases; or

    monotonically increasing or decreasing a digital signal (W) provided by said digital counter, providing a single ramp in which the offset current (I_OFFSET) monotonically increases.

8.  A differential amplifier arrangement (10), comprising:

    an adjustment circuit block (20) configured to generate at least one adjustment signal (IN_OFFSET_SX, IN_OFFSET_DX; GATE_SX, GATE_DX);

    an operational amplifier circuit (12, 12') comprising a first (120) and a second (122) input node configured to receive at least one input signal (INP, INM; IN_CALIB), respectively; and at least one output node (128) configured to provide at least one output signal (OUT), as well as a first (Vdd) and a second (GND) supply node configured to receive a first and a second supply voltage level, respectively;

    at least one adjustment node (123, 125) coupled to the operational amplifier circuit (12, 12') and to the adjustment circuit block (20) to receive the at least one adjustment signal (IN_OFFSET_SX, IN_OFFSET_DX; GATE_SX, GATE_DX therefrom;

    wherein the operational amplifier stage (12; 12') is configured to generate the at least one output signal (OUT) based on said at least one input signal (INP, INM; IN_CALIB), the amplifier offset and at least one adjustment signal (IN_OFFSET_SX, IN_OFFSET_DX; GATE_SX, GATE_DX);

    control circuitry (14) configured to operate the differential amplifier arrangement (10) according to the method of any one of claims 1 to 7.

9.  An integrated circuit, comprising a differential amplifier arrangement (10) according to claim 8.

10. A system, such as a DC-DC converter (80) or a sensor, comprising a differential amplifier arrangement (10) according to claim 8.

# FIG. 1

# FIG. 2

FIG. 3

EP 4 738 703 A1

FIG. 4

FIG. 5

EP 4 738 703 A1

FIG. 6

EP 4 738 703 A1

## FIG. 7

OSC_EXT_CALIB

CALIB ------T*

D_MUX_OUT

OUT_DIG_OPAM

CALIB_OUT_B

## FIG. 8

OUT

INP

T**

EP 4 738 703 A1

EP 4 738 703 A1

FIG. 9

# FIG. 10

# FIG. 11

Europäisches
Patentamt
European
Patent Office
Office européen
des brevets

# EUROPEAN SEARCH REPORT

**Application Number**

EP 25 20 8093

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 117 155 303 A (SG MICROELECTRONICS BEIJING CO LTD) 1 December 2023 (2023-12-01) | 1-4,6-10 | INV. H03F3/45 |
| A | * figures 1,2,3 * | 5 | |
| X | TSIRMPAS GEORGE ET AL: "A high-speed dynamic comparator with automatic offset calibration", AEU - INTERNATIONAL JOURNAL OF ELECTRONICS AND COMMUNICATIONS , vol. 186 10 August 2024 (2024-08-10), page 155472, XP093272792, AMSTERDAM, NL ISSN: 1434-8411, DOI: 10.1016/j.aeue.2024.155472 Retrieved from the Internet: URL:https://pdf.sciencedirectassets.com/273242/1-s2.0-S1434841124X00114/1-s2.0-S1434841124003583/main.pdf? [retrieved on 2025-04-25] | 1,3,4, 6-10 | |
| A | * page 1, left-hand column, line 2 - page 8, line 17; figures 1-13 * | 2,5 | TECHNICAL FIELDS SEARCHED (IPC) H03F |
| X | US 2011/074505 A1 (CHIANG YU-CHEN [TW] ET AL) 31 March 2011 (2011-03-31) | 1,3,4, 6-10 | |
| A | * paragraphs [0002] - [0045]; figures 1-8 * | 2,5 | |

The present search report has been drawn up for all claims

| Place of search | Date of completion of the search | Examiner |
|---|---|---|
| The Hague | 5 February 2026 | Fedi, Giulio |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 ...................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 20 8093

05-02-2026

| Patent document cited in search report | | Publication date | Patent family member(s) | | Publication date |
|---|---|---|---|---|---|
| CN 117155303 | A | 01-12-2023 | NONE | | |
| US 2011074505 | A1 | 31-03-2011 | TW | 201112617 A | 01-04-2011 |
| | | | US | 2011074505 A1 | 31-03-2011 |

EPO FORM P0459

**EP 4 738 703 A1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2019363686 A1

- US 2007109043 A1